# FASCICULE DE BREVET EUROPEEN

(11) **EP 3 144 272 B1**
(45) Date de publication et mention de la délivrance du brevet: **18.04.2018**
(21) Numéro de dépôt: 16189046.2
(22) Date de dépôt: 15.09.2016
(51) Int. Cl.: B82B 3/00

(54) **PROCEDE D'ORIENTATION D'OBJETS ALLONGÉS DISPOSES EN SURFACE D'UN SUBSTRAT**
METHOD FOR ORIENTING ELONGATE OBJECTS ARRANGED ON THE SURFACE OF A SUBSTRATE
VERFAHREN ZUR AUSRICHTUNG AUF EINER SUBSTRATOBERLFÄCHE ANGEORDNETER LÄNGLICHER OBJEKTE

(30) Priorité: 17.09.2015 FR 1558717
(43) Date de publication de la demande: 22.03.2017
(73) Titulaire: COMMISSARIAT À L'ÉNERGIE ATOMIQUE ET AUX ÉNERGIES ALTERNATIVES, 75015 Paris (FR)
(72) Inventeur: EYMERY, Joël, 38360 Sassenage (FR); EL KACIMI, Amine, 38000 Grenoble (FR); DELLEA, Olivier, 42350 La Talaudiere (FR); PAULIAC-VAUJOUR, Emmanuelle, 38430 Moirans (FR)
(74) Mandataire: Cabinet Camus Lebkiri

(56) Documents cités:
- US-A1- 2010 203 316

## Description

### DOMAINE TECHNIQUE DE L'INVENTION

Le domaine technique de l'invention est celui de la science des matériaux, et plus particulièrement celui des objets fabriqués sur un substrat.

L'invention se rapporte à un procédé d'orientation d'objets allongés disposés en surface d'un substrat.

### ARRIERE-PLAN TECHNOLOGIQUE DE L'INVENTION

Différents objets allongés, parmi lesquels des nano-objets tels que les nanofils ou les nanotubes, sont actuellement utilisés pour de nombreuses applications. Les nanofils servent par exemple à fabriquer des dispositifs piézoélectriques, comme des capteurs de déformations capacitifs, ou des dispositifs optiques comme des diodes électroluminescentes ou des dispositifs photovoltaïques.

Il existe deux méthodes majeures pour fabriquer des nano-objets. La première méthode consiste à faire croître les nano-objets dans une solution, sans substrat. Dans ce cas, les nano-objets sont dispersés dans la solution. La deuxième méthode consiste à faire croître les nano-objets à partir d'un substrat, selon une même direction par rapport à la surface du substrat.

Parmi les techniques de croissance des nano-objets, on peut notamment citer l'épitaxie par jet moléculaire, également appelée MBE pour « Molecular Beam Epitaxy » en anglais, et l'épitaxie en phase gazeuse utilisant par exemple des molécules de type organométalliques ou hydrures en tant que sources gazeuses, respectivement appelées MOVPE pour « Metal Organic Vapor Phase Epitaxy » et HVPE pour « Hydride Vapor Phase Epitaxy » en anglais.

Les nano-objets peuvent également être obtenus par d'autres méthodes comme des croissances chimiques en phase liquide ou des approches descendantes (« top-down » en anglais) basées sur des procédés de lithographie et de gravure.

Les nano-objets sont anisotropes, c'est-à-dire qu'ils possèdent une ou plusieurs propriétés physiques variant selon la direction considérée. De ce fait, il est nécessaire pour certaines applications d'orienter les nano-objets dans une direction souhaitée. En effet, lorsque la caractéristique physique considérée est orientée, il est nécessaire d'orienter cette caractéristique de tous les nano-objets dans un même sens. En effet, des nano-objets disposés dans une même direction mais tête-bêche, c'est-à-dire dans des sens opposés, peuvent voir leurs réponses à une excitation s'annuler plutôt que de s'additionner. C'est le cas par exemple dans le domaine de la piézoélectricité.

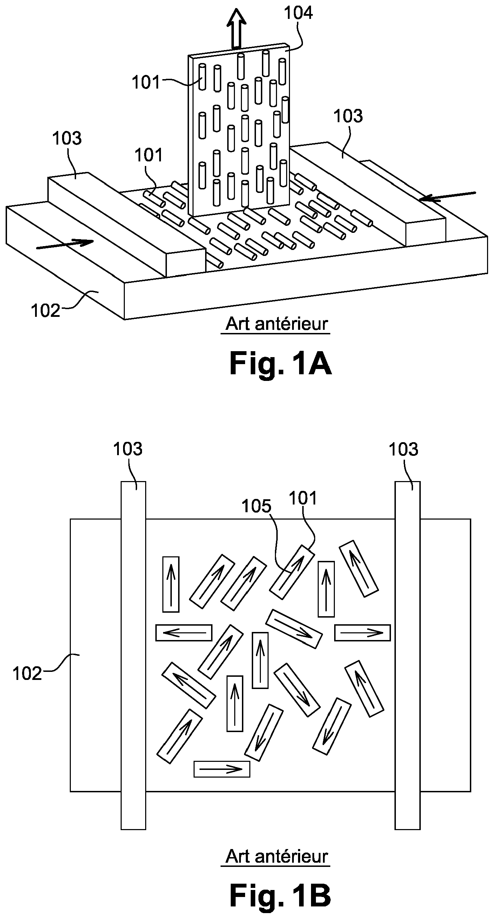

Un procédé connu d'orientation de nanofils est la méthode de Langmuir-Blodgett, représentée sur les figures 1A et 1B. Toutefois, cette méthode n'est applicable qu'à des nanofils 101 dispersés dans une solution 102. Par conséquent, pour orienter des nanofils 101 fabriqués à partir d'un substrat, il est tout d'abord nécessaire de les disperser dans la solution 102. Ensuite, après l'ajout de ligands chimiques, les nanofils 101 en suspension dans la solution 102 remontent en surface et forment une couche de nanofils 101. La densité de nanofils 101 en surface de la solution 102 est contrôlée par le déplacement de barrières hydrophobes 103 qui exercent une pression sur la couche de nanofils 101. Les nanofils 101 sont ensuite transférés sur un support 104, celui-ci étant plongé dans la solution 102 puis retiré de la solution 102. Un premier inconvénient de cette méthode est que ces étapes technologiques coûtent cher et prennent du temps.

Par ailleurs, sur le support 104, les nanofils 101 sont globalement parallèles les uns aux autres mais le sens de leur axe cristallographique n'est pas toujours le même. La figure 1B est une vue de dessus de la surface de la solution 102 et montre la perte d'orientation des nanofils 101, les axes cristallographiques étant représentés pas des flèches 105.

Avec cette méthode, les nanofils 101 ont également tendance à se chevaucher et à former des fagots, ce qui peut gêner, selon l'application visée, le fonctionnement du dispositif final dans lequel est disposé le support 104. Ainsi, la méthode Langmuir-Blodgett ne permet d'assembler des nanofils 101 que sur de petites surfaces, jusqu'à 16 cm², car pour des surfaces plus grandes, l'inhomogénéité de la pression exercée uniquement sur les bords de la couche de nanofils 101 serait trop importante. US 2010/203316 A1 divulgue un procédé d'orientation de nanotubes de carbone disposés en surface d'un substrat. Selon ce procédé une pression est exercée par un rouleau de façon à incliner les nanotubes et les faire adhérer à une feuille de transfert. Après, une couche en résine époxy est déposée sur les nanotubes inclinés.

### RESUME DE L'INVENTION

La présente invention vise à améliorer le contrôle de l'orientation d'objets allongés disposés en surface d'un substrat en choisissant une direction et un sens dans lesquels orienter les objets allongés, ce qui de ce fait empêche le chevauchement des objets allongés et la formation de fagots. Parallèlement à l'amélioration du contrôle de l'orientation des objets allongés, la présente invention vise également à réduire le temps et les moyens nécessaires à l'orientation des objets allongés tout en augmentant la surface sur laquelle les objets allongés sont orientés.

Dans le texte qui suit et qui précède, ainsi que dans les revendications, le terme « objets allongés » désigne des objets s'étendant sur un substrat selon une direction privilégiée et présentant un facteur de forme supérieur ou égal à 10. La direction privilégiée forme un angle quelconque avec le substrat. Les objets allongés ont une section quelconque, de préférence elliptique ou polygonale. Les objets allongés sont par exemple obtenus par croissance en phase gazeuse ou liquide, ou par des procédés de lithographie et de gravure. De plus, les objets allongés présentent de préférence au moins une propriété physique tensorielle dont les vecteurs principaux sont orientés de façon quelconque par rapport à la direction privilégiée des objets allongés.

L'invention concerne un procédé d'orientation d'objets allongés disposés en surface d'un substrat, les objets allongés s'étendant selon une direction initiale, le procédé comportant les étapes suivantes :
- déposer sur la surface du substrat au moins une couche d'une matière molle recouvrant au moins partiellement une partie des objets allongés ;
- appliquer une contrainte mécanique sur au moins une partie de la couche de matière molle de façon à modifier l'orientation d'au moins une partie des objets allongés.

La matière molle est une matière dans laquelle les interactions entre les éléments la constituant sont très faibles, de l'ordre de l'excitation thermique. Cela peut notamment aller de matières plastiques à des bulles de savon, en passant par des gels, des élastomères, des cristaux liquides, des crèmes cosmétiques, des boues et des pâtes céramiques. Cette caractéristique fait que la matière molle englobe facilement les objets allongés sans les casser et sans laisser de cavités. De plus, la matière molle présente une susceptibilité importante par rapport à des sollicitations extérieures telles qu'une déformation mécanique.

C'est grâce au fait que la matière molle recouvre les objets allongés que ceux-ci peuvent être orientés par l'application d'une contrainte mécanique sur la couche de matière molle, le déplacement de celle-ci entraînant à sa suite le déplacement des objets allongés. Il est possible de choisir une direction et un sens pour l'orientation des objets allongés en jouant sur la contrainte mécanique appliquée.

De plus, les objets allongés sont orientés directement sur le substrat de croissance. Il est alors possible de se passer d'étapes technologiques qui coûtent cher et qui prennent du temps, comme l'étape préalable de dispersion des objets allongés dans une solution. Le temps et les moyens nécessaires à l'orientation des objets allongés sont donc réduits. Le fait de travailler directement sur le substrat implique également de pouvoir orienter les objets allongés sur une plus grande surface, le substrat possédant une surface pouvant atteindre plusieurs mètres carrés.

Le procédé selon l'invention peut également comporter une ou plusieurs caractéristiques parmi les suivantes, considérées individuellement ou selon les combinaisons techniquement possibles :
- les objets allongés présentent une longueur selon leur direction initiale, la couche de matière molle présentant une épaisseur au moins égale à la longueur des objets allongés ;
- la contrainte mécanique appliquée sur ladite au moins une partie de la couche de matière est une contrainte de cisaillement et/ou une contrainte de torsion ;
- la contrainte mécanique est appliquée au moyen d'un tampon exerçant une pression sur ladite au moins une partie de la couche de matière molle ;
- la contrainte mécanique est appliquée sur la totalité de la couche de matière molle au moyen d'une plaque ;
- le procédé comporte une étape de modification de la viscosité de la couche de matière molle ;
- la modification de la viscosité de la couche de matière molle est effectuée au moyen d'un recuit, d'une réaction chimique ou d'une exposition à un rayonnement ;
- le procédé comporte une étape de pelage au cours de laquelle la couche de matière molle, avec les objets allongés, est séparée du substrat ;
- le procédé comporte une étape de suppression partielle ou totale de la couche de matière molle ;
- le procédé comporte une étape de dépôt d'au moins une couche supplémentaire sur la couche de matière molle, avant ou après l'application de la contrainte mécanique ;
- la contrainte mécanique est appliquée sur la couche supplémentaire ;
- le procédé comporte une étape de suppression partielle ou totale de la couche supplémentaire ;
- l'étape de suppression est réalisée par évaporation, par dissolution chimique ou par gravure ;
- la matière molle est du cyclododécane ou un polymère choisi parmi les suivants : polydiméthylsiloxane, polyéthylène glycol, poly(méthacrylate de méthyle) ;
- la matière molle est un matériau présentant une propriété électrique ou optique.

Le procédé selon l'invention s'applique tout particulièrement dans le cas où les objets allongés présentent au moins une dimension inférieure à 10 µm, et encore plus particulièrement dans le cas où les objets allongés présentent au moins une dimension inférieure à 1 µm.

### BREVE DESCRIPTION DES FIGURES

L'invention et ses différentes applications seront mieux comprises à la lecture de la description qui suit et à l'examen des figures qui l'accompagnent, parmi lesquelles :
- les figures 1A et 1B représentent schématiquement un procédé d'orientation de nanofils, appelé « méthode de Langmuir-Blodgett » selon l'art antérieur ;
- les figures 2A à 2D représentent schématiquement des étapes de l'orientation d'objets allongés disposés en surface d'un substrat, d'après un premier mode de mise en oeuvre du procédé selon l'invention ;
- la figure 3 représente un diagramme fonctionnel du mode de mise en oeuvre des figures 2A à 2D ;
- la figure 4 représente schématiquement un deuxième mode de mise en oeuvre du procédé d'orientation d'objets allongés selon l'invention ;
- la figure 5 est une vue de dessus des objets allongés orientés de la figure 4 ;
- la figure 6 représente schématiquement une variante de mise en oeuvre du procédé d'orientation d'objets allongés selon l'invention, plusieurs couches de matière molle et une couche supplémentaire étant déposées.

Les figures ne sont présentées qu'à titre indicatif et nullement limitatif de l'invention.

Pour plus de clarté, les éléments identiques ou similaires sont repérés par des signes de référence identiques sur toutes les figures.

### DESCRIPTION DETAILLEE D'UN MODE DE REALISATION DE L'INVENTION

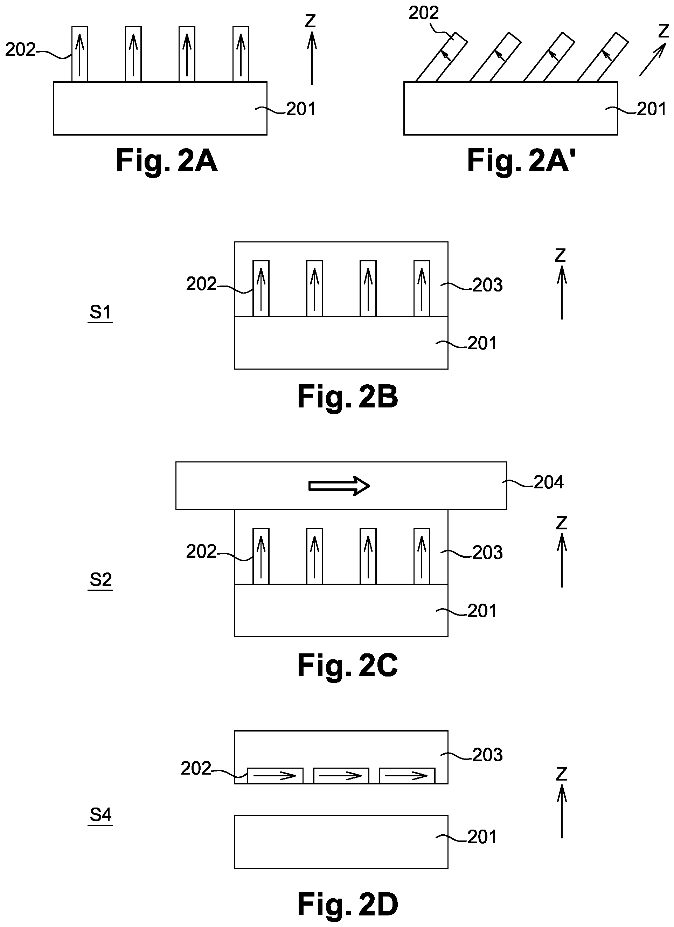

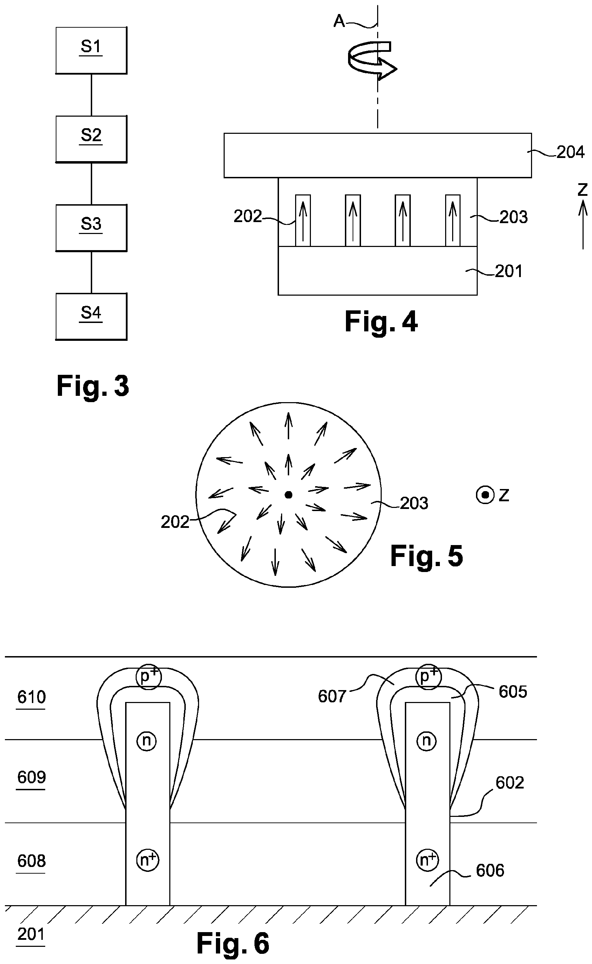

Un premier mode de mise en oeuvre du procédé d'orientation d'objets allongés disposés en surface d'un substrat selon l'invention va maintenant être décrit, en faisant conjointement référence aux figures 2A à 2D et à la figure 3.

La figure 2A montre un substrat 201 comportant des objets allongés 202 s'étendant selon une direction initiale Z. La direction initiale Z est la direction privilégiée des objets allongés 202. Dans ce mode de réalisation, la direction initiale Z est orthogonale à la surface du substrat 201. Dans une variante de mise en oeuvre, les objets allongés sont initialement inclinés par rapport à la surface du substrat 201, la direction initiale Z des objets allongés formant alors un angle compris entre 0 et 90° avec la surface du substrat. Le substrat est par exemple du saphir, du silicium, de l'oxyde de zinc, du verre ou du plastique.

Les objets allongés 202 disposés en surface du substrat 201 sont par exemple des nanofils ou des nanotubes. Les objets allongés 202 sont par exemple en nitrure de gallium (GaN) ou en oxyde de zinc (ZnO). De manière générale, les objets allongés 202 présentent un facteur de forme supérieur ou égal à 10. En d'autres termes, chaque objet allongé 202 présente une longueur selon la direction initiale Z au moins 10 fois plus grande que ses autres dimensions, par exemple son diamètre, sa largeur ou son épaisseur.

Les objets allongés 202 peuvent être obtenus par différentes technique telles que l'épitaxie par jet moléculaire, également appelée MBE pour « Molecular Beam Epitaxy » en anglais, l'épitaxie en phase gazeuse utilisant par exemple des molécules de type organométalliques ou hydrures en tant que sources gazeuses, respectivement appelées MOVPE pour « Metal Organic Vapor Phase Epitaxy » et HVPE pour « Hydride Vapor Phase Epitaxy » en anglais.

A titre d'exemple, des nanofils réalisés par épitaxie par jet moléculaire ont une longueur comprise entre 10 nm et 5 µm, un diamètre compris entre 10 nm et 100 nm, et une densité surfacique pouvant atteindre 10¹² cm⁻². Des nanofils réalisés par épitaxie en phase vapeur ont quant à eux une longueur comprise entre 100 nm et quelques millimètres, un diamètre compris entre 20 nm et 5 µm, et une densité surfacique pouvant atteindre 10⁹ cm⁻².

La densité surfacique des objets allongés 202 définit la séparation moyenne entre les objets allongés 202. Il s'agit d'un paramètre qui peut s'avérer crucial selon l'application à laquelle les objets allongés 202 sont destinés.

De manière générale, les objets allongés 202 obtenus par épitaxie croissent à partir du substrat et l'axe de croissance peut être quelconque par rapport à la surface du substrat 201. Par exemple, le document KOESTER, R., M-Plane Core-Shell InGaN/GaN Multiple-Quantum-Wells on GaN Wires for Electroluminescent Devices, Nano Letters octobre 2011, vol. 11, n° 11, pages 4839, 4845 décrit des nanofils perpendiculaires au substrat, et le document TESSAREK, C., Optical properties of vertical, tilted and in-plane GaN nanowires on différent crystallographic orientations of sapphire, Journal of Physics D : Applied Physics septembre 2014, vol. 47, n° 39 décrit des nanofils ayant des inclinaisons très différentes selon les conditions de croissance. Cependant, dans tous les cas, les objets allongés 202 sont parallèles entre eux.

De plus, les objets allongés 202 peuvent présenter des propriétés physiques identiques. Par exemple, la polarité cristallographique, représentée par une flèche sur la figure 2A, a la même orientation et le même sens pour tous les objets allongés 202. Toutefois, de façon générale, cette flèche n'est pas nécessairement parallèle à la direction initiale Z de l'objet allongé 202, comme illustré sur la figure 2A'.

D'autres méthodes peuvent être utilisées pour obtenir les objets allongés 202 comme des croissances chimiques en phase liquide en utilisant un substrat ou des approches descendantes (« top-down » en anglais) basées sur des procédés de lithographie et de gravure.

La figure 2B illustre une étape S1 de dépôt d'une couche 203 de matière molle sur le substrat 201. C'est au moyen de cette couche 203 de matière molle que les objets allongés 202 vont être orientés. De préférence, la couche 203 de matière molle présente une épaisseur au moins égale à la longueur des objets allongés 202. Ainsi les objets allongés 202 sont entièrement noyés dans la couche 203 de matière molle ce qui facilitera leur orientation et permettra d'éviter de leur causer des dommages.

Comme illustré sur la figure 2B, la couche 203 de matière molle est déposée de manière à recouvrir la totalité des objets allongés 202. Dans une variante de mise en oeuvre, la couche 203 de matière molle est déposée de manière à recouvrir une partie seulement des objets allongés 202, cette partie comportant les objets allongés 202 que l'on souhaite orienter. Il est également possible de déposer la couche 203 de matière molle sur toute la surface du substrat et d'en supprimer une partie, par exemple par gravure.

La matière molle de cette couche 203 est par exemple du cyclododécane (CDD) ou un polymère, comme du polydiméthylsiloxane (PDMS), du polyéthylène glycol (PEG), du poly(méthacrylate de méthyle) (PMMA). La matière molle peut également être un polymère thermoplastique, comme du polystyrène ou du polycarbonate, ou thermodurcissable, comme de la Bakélite ou de la résine époxy, ou encore un polymère à mémoire de forme, comme du tricyclodecane dimethanol diacrylate (TCMDA), du 1,3,5-triallyl-1,3,5-triazine-2,4,6(1H,3H,5H)-trione (TATATO) et du 2,2-dimethoxy-2-phenyl acetophenone (DMPA).

Un critère à prendre en compte dans le choix de la matière molle est l'application à laquelle les objets allongés 202 sont destinés. Par exemple, un matériau diélectrique sera choisi pour contrôler le transport de charges et les propriétés électrostatiques. On s'attachera alors à optimiser la constante diélectrique du matériau mais d'autres propriétés électriques peuvent être envisagées, par exemple en utilisant des polymères conducteurs. Pour une application à des dispositifs optiques, la matière molle possédera des propriétés optiques particulières, notamment au niveau de sa transmission, son absorption, sa réflexion. Dans ce cas, ce sont les indices optiques qu'il faudra optimiser.

La couche 203 de matière molle est déposée selon une technique qui dépend de la matière molle choisie ainsi que de l'état physique dans lequel elle se trouve, solide, liquide ou gazeux. Lorsque la matière molle est initialement à l'état liquide, elle est par exemple déposée par une technique appelée dépôt à la tournette ou « spin-coating » selon la terminologie anglo-saxonne. La matière molle est déposée au centre du substrat 201 puis celui-ci est mis en rotation. La matière molle s'étale alors sur la surface du substrat 201 sous l'effet de la force centrifuge. Cette technique est par exemple utilisée pour déposer du PDMS.

Lorsque la matière molle est initialement à l'état solide, comme le parylène, on peut utiliser une technique de dépôt sous vide par évaporation ou des procédés à base de plasma. Enfin, pour une matière molle initialement à l'état gazeux, comme le paracyclophane, il existe des procédés de dépôt à basse pression.

Après le dépôt de la couche 203 de matière molle, une contrainte mécanique est appliquée à celle-ci, au cours d'une étape S2 illustrée sur la figure 2C. La contrainte mécanique permet de modifier l'orientation des objets allongés 202. Dans ce premier mode de mise oeuvre, la contrainte mécanique est appliquée sur toute la surface de la couche 203 de matière molle et de manière uniforme, par exemple au moyen d'une plaque 204. En d'autres termes, la contrainte mécanique présente un vecteur identique en tout point de la surface afin d'agir de la même manière sur chaque objet allongé 202 et ainsi conserver l'orientation relative entre eux.

Dans des variantes de mise en oeuvre, des tampons sont utilisés pour agir localement sur la couche 203 de matière molle. Ces tampons présentent alors des formes et des tailles ajustables, chaque tampon appliquant une contrainte mécanique à la couche 203 de matière molle. Il est ainsi possible de modifier l'orientation d'une partie seulement des objets allongés 202 ou d'orienter les objets allongés 202 par groupes, de façon indépendante les uns des autres. Dans ce cas, les contraintes mécaniques peuvent être appliquées simultanément ou de manière séquentielle.

De préférence, la plaque 204, ou les tampons, sont disposés de manière à exercer une pression sur la couche 203 de matière molle. Plusieurs solutions sont alors possibles afin d'appliquer la contrainte mécanique à la couche 203 de matière molle. Une première solution consiste à maintenir le substrat 201 fixe et à déplacer la plaque 204, comme illustré sur la figure 2C, le déplacement de la plaque 204 étant symbolisé par une flèche ayant une direction perpendiculaire à la direction initiale Z des objets allongés 202. Inversement, une deuxième solution consiste à maintenir la plaque 204 fixe et à déplacer le substrat 201. Enfin, une troisième solution consiste à déplacer le substrat 201 et la plaque 204 dans des sens opposés.

La contrainte mécanique appliquée se décompose en contraintes élémentaires de types cisaillement et torsion. Dans ce premier mode de mise en oeuvre, la contrainte mécanique appliquée sur la couche 203 de matière molle est une contrainte de cisaillement. Avec une contrainte de cisaillement, les objets allongés 202 sont inclinés d'un angle compris entre -90° et 90° par rapport à la normale à la surface du substrat. Dans le mode de mise en oeuvre des figures 2A à 2D, la plaque 204 effectue un déplacement suffisant pour coucher les objets allongés 202. Ces derniers peuvent casser à leur base, c'est-à-dire au niveau de l'interface qu'ils forment avec le substrat 201. En effet, à cette interface, les objets allongés 202 peuvent présenter des défauts, des dislocations ou une concentration de contraintes. Cependant, dans le cas par exemple d'objets allongés 202 très fins, ceux-ci peuvent se courber sans se rompre au niveau de leur base si la déformation des objets allongés 202 reste dans le domaine élastique.

Le procédé selon l'invention comporte avantageusement une étape S3, représentée sur la figure 3, de modification de la viscosité de la matière molle de la couche 203. Cette étape consiste à modifier les propriétés mécaniques de la couche 203 de matière molle. Il est par exemple possible de faire durcir la couche 203 de matière molle afin de figer l'orientation des objets allongés 202. Il est également possible de ramollir la couche 203 de matière molle pour continuer à travailler dessus.

Il existe différentes méthodes de modification de la viscosité de la matière molle. La méthode utilisée dépend du choix de la matière molle. La couche 203 de matière molle est par exemple soumise à une variation de température comme un recuit si l'on veut la faire durcir. A titre d'exemple, le recuit d'une couche de PDMS est effectué à une température de 80°C pendant 50 mn. En effet, le degré de réticulation de ce polymère est modifié sous l'effet de la variation de température.

Il est également possible de jouer sur les températures de transition vitreuse, de fusion et de fluidification de la matière molle. Ainsi, il est possible de faire passer la matière molle d'un état vitreux à un état caoutchouteux ou visqueux. Les coefficients élastiques varient beaucoup avec ces changements d'état, ce qui permet en pratique d'explorer de larges gammes de déplacements pour une même force appliquée.

La modification de la viscosité de la couche 203 de matière molle peut aussi être effectuée par réaction chimique. Dans ce cas, la couche 203 de matière molle est par exemple placée en contact avec un gaz ou une solution afin de modifier la nature des liaisons chimiques qui la constituent. Ainsi, les propriétés physiques de la couche 203 de matière molle sont également modifiées.

Une autre méthode consiste à exposer la couche 203 de matière molle à un rayonnement, par exemple de photons ou d'ions, qui entraîne une modification du degré de réticulation ou de séchage, de la couche 203 de matière molle.

Avantageusement, le procédé selon l'invention comporte une étape S4 de pelage, illustré sur la figure 2D, au cours de laquelle la couche 203 de matière molle avec les objets allongés 202 est séparée du substrat. Ainsi, la couche 203 de matière molle avec les objets allongés 202 peut être intégrée dans un dispositif ou subir de nouvelles opérations. De préférence, l'étape S4 de pelage est effectuée après avoir suffisamment fait durcir la couche 203 de matière molle, comme illustré sur la figure 3. Cela permet ainsi d'éviter de désorienter les objets allongés 202 en appliquant à la couche 203 de matière molle des contraintes mécaniques générées au cours de l'étape S4 de pelage. Une fois pelée, la couche 203 de matière molle avec les objets allongés 202 peut par exemple être disposée entre deux électrodes métalliques pour former un capteur piézoélectrique capacitif.

Grâce au procédé selon l'invention, on s'affranchit des problèmes présents avec la méthode Langmuir-Blodgett. Tout d'abord, on évite la désorientation des objets allongés 202. En effet, il est possible d'orienter les objets allongés 202 dans une même direction et dans un même sens ce qui permet d'obtenir une addition des propriétés physiques individuelles de chaque objet allongé 202.

De plus, les objets allongés 202 ne forment pas de fagots qui gêneraient le fonctionnement du capteur, par exemple en créant des courts-circuits entre les électrodes. Par ailleurs, les étapes du procédé sont moins nombreuses et plus faciles à mettre en oeuvre ce qui réduit le temps et le coût nécessaire à l'orientation des objets allongés.

Enfin, il est possible de travailler sur de grandes surfaces, qui peuvent par exemple atteindre plusieurs mètres carrés. En effet, aujourd'hui les substrats en saphir ou en silicium sont des plaquettes ayant un diamètre de 450 mm, les substrats en verre ont des dimensions de préférence inférieures au mètre et les substrats souples peuvent être utilisés sous forme de bandes déroulées de plusieurs mètres carrés. Les dimensions des substrats sont seulement limitées par les machines de fabrication des objets allongés 202.

Un deuxième mode de mise en oeuvre du procédé d'orientation d'objets allongés va maintenant être décrit en référence à la figure 4. Comme dans le premier mode de mise en oeuvre du procédé, on fournit un substrat 201 comportant des objets allongés 202 s'étendant selon une direction initiale Z par exemple orthogonale à la surface du substrat 201. Les objets allongés 202 sont recouverts par une couche 203 de matière molle et une plaque 204 est disposée sur cette dernière de manière à exercer une pression dessus.

Dans ce deuxième mode de mise en oeuvre, les objets allongés 202 sont des fils destinés à la fabrication d'une diode électroluminescente. Les fils sont par exemple en nitrure de gallium (GaN) et ont une structure coeur-coquille avec des puits quantiques en nitrure de gallium-indium (InGaN). Chaque fil présente un cône d'émission intrinsèque ayant la même direction que la direction initiale Z. La contrainte mécanique appliquée est ici une contrainte de torsion. Le substrat 201 est maintenu fixe et la plaque 205 est mise en rotation autour d'un axe A parallèle à la direction initiale Z des objets allongés 202.

La figure 5 montre en vue de dessus l'inclinaison des objets allongés 202 orientés de la figure 4. Dans le cas d'une torsion, le déplacement latéral est nul au niveau de l'axe de rotation A et est maximal en périphérie de la couche 203 de matière molle. Les objets allongés 202 s'inclinent alors d'un angle qui dépend de la distance qui sépare les objets allongés 202 de l'axe de rotation A. En d'autres termes, plus les objets allongés 202 sont éloignés de l'axe de rotation A, plus ils sont inclinés. Ainsi, le champ d'émission de l'ensemble des objets allongés 202 est structuré par la désorientation de chacun des cônes d'émission.

Dans l'art antérieur, pour former les diodes électroluminescentes, les objets allongés 202 sont encapsulées dans des éléments optiques dispersifs, se présentant par exemple sous la forme de dômes, afin d'augmenter le diagramme d'émission des diodes. Grâce à l'invention, il est possible de supprimer l'étape d'encapsulation ou au moins de la simplifier en plaçant par exemple juste une couche de protection. De ce fait, les diodes seront également plus plates.

Dans les deux modes de mise en oeuvre du procédé décrits précédemment, la couche 203 de matière molle est conservée. Dans des variantes de mise en oeuvre, après avoir appliqué la contrainte mécanique à la couche 203 de matière molle, cette dernière est supprimée, en partie ou dans son intégralité. Dans ce cas, la couche de matière molle est dite « sacrificielle ». Il est par exemple possible d'effectuer une attaque partielle de la couche 203 de matière molle pour libérer le sommet des objets allongés 202 afin de réaliser des contacts électriques.

La couche de matière molle est supprimée par exemple au cours d'une étape d'évaporation. Dans ce cas, la matière molle choisie présente de préférence une faible température de sublimation. C'est le cas par exemple du cyclododécane (CDD) qui à température ambiante se présente sous forme solide et qui possède une température de sublimation d'environ 60 °C. La couche de matière molle peut également être supprimée par voie chimique ou physique, comme une dissolution ou une gravure.

Dans une variante de mise en oeuvre, le procédé comporte une étape de dépôt, sur la couche 203 de matière molle, d'au moins une couche supplémentaire présentant une rigidité différente de celle de la couche de matière molle. On obtient alors un empilement comportant le substrat 201, la couche 203 de matière molle et la couche supplémentaire. La couche supplémentaire est par exemple déposée au moyen d'une technique utilisée pour le dépôt de la couche 203 de matière molle. Eventuellement, la contrainte mécanique est appliquée sur la couche supplémentaire puis transmise à la couche 203 de matière molle via l'interface entre la couche supplémentaire et la couche 203 de matière molle.

L'ajout de la couche supplémentaire peut avoir plusieurs objectifs qui conditionneront le choix d'un matériau à partir duquel la couche supplémentaire est réalisée. Un premier objectif de la couche supplémentaire est d'ajuster la répartition de la contrainte mécanique appliquée sur la couche 203 de matière molle au travers de l'interface entre la couche supplémentaire et la couche 203 de matière molle. Dans ce cas, la viscosité et les modules élastiques du matériau de la couche supplémentaire ainsi que les glissements relatifs à l'interface doivent être adaptés et quantifiés. Cela permet par ailleurs de contrôler le déplacement final des objets allongés 202, en particulier si la rigidité de la couche supplémentaire est plus faible que celle de la couche 203 de matière molle. En effet, un déplacement millimétrique appliqué à la couche supplémentaire peut impliquer un déplacement micrométrique au niveau des objets allongés 202.

Un deuxième objectif de la couche supplémentaire est d'augmenter la rigidité de l'empilement permettant ainsi de faciliter le pelage ou le transfert de la couche 203 de matière molle. Il s'agit d'une fonction de poignée. Dans ce cas, la rigidité de la couche supplémentaire est plus grande que celle de la couche 203 de matière molle.

Un troisième objectif de la couche supplémentaire est d'ajouter une fonctionnalité au dispositif final auquel les objets allongés sont destinés. La couche supplémentaire peut par exemple apporter une conduction électrique ou permettre d'adapter un indice optique.

Dans une autre variante de mise en oeuvre, il est possible d'empiler plusieurs couches de matières molles différentes et plusieurs couches supplémentaires différentes. Les couches de matières molles et les couches supplémentaires peuvent être alternées. La figure 6 illustre le cas d'un substrat 201 sur lequel sont disposés des fils 602 de nitrure de gallium comportant des multipuits quantiques 605 en nitrure de gallium-indium. Chaque fil 602 présente une base 606 dopée n et une partie supérieure 607 dopée p.

Une première couche 608 d'une première matière molle conductrice est déposée sur le substrat pour injecter du courant dans la base 606 des fils 602. Ensuite, une couche supplémentaire isolante 609 est déposée sur la première couche 608. Une deuxième couche 610 d'une deuxième matière molle conductrice est déposée sur la couche supplémentaire isolante 609 afin de prendre le contact électrique sur la partie supérieure 607 des fils 602. La première matière molle et la deuxième matière molle peuvent être identiques ou différentes. Le procédé selon l'invention est appliqué à l'ensemble des couches 608, 609, 610.

Naturellement l'invention n'est pas limitée aux modes de mise en oeuvre décrits en référence aux figures et des variantes pourraient être envisagées sans sortir du cadre de l'invention.

## Revendications

1. Procédé d'orientation d'objets allongés (202) disposés en surface d'un substrat (201), les objets allongés (202) s'étendant selon une direction initiale (Z), le procédé comportant les étapes suivantes :
- déposer (S1) sur la surface du substrat (201) au moins une couche (203) d'une matière molle recouvrant au moins partiellement une partie des objets allongés ;
- appliquer (S2) une contrainte mécanique sur au moins une partie de la couche (203) de matière molle de façon à modifier l'orientation d'au moins une partie des objets allongés (202).

2. Procédé selon la revendication 1 dans lequel les objets allongés (202) présentent une longueur selon leur direction initiale (Z), la couche (203) de matière molle présentant une épaisseur au moins égale à la longueur des objets allongés (202).

3. Procédé selon l'une quelconque des revendications 1 et 2 dans lequel la contrainte mécanique appliquée sur ladite au moins une partie de la couche (203) de matière molle est une contrainte de cisaillement et/ou une contrainte de torsion.

4. Procédé selon l'une quelconque des revendications 1 à 3 dans lequel la contrainte mécanique est appliquée au moyen d'un tampon exerçant une pression sur ladite au moins une partie de la couche (203) de matière molle.

5. Procédé selon l'une quelconque des revendications 1 à 4 comportant une étape de modification (S3) de la viscosité de la couche (203) de matière molle.

6. Procédé selon la revendication 5 dans lequel la modification de la viscosité de la couche (203) de matière molle est effectuée au moyen d'un recuit, d'une réaction chimique ou d'une exposition à un rayonnement.

7. Procédé selon l'une quelconque des revendications 1 à 6 comportant une étape de pelage (S4) au cours de laquelle la couche (203) de matière molle, avec les objets allongés (202), est séparée du substrat (201).

8. Procédé selon l'une quelconque des revendications 1 à 6 comportant une étape de suppression partielle ou totale de la couche (203) de matière molle.

9. Procédé selon l'une quelconque des revendications 1 à 7 comportant une étape de dépôt d'au moins une couche supplémentaire (609) sur la couche (203) de matière molle, avant ou après l'application de la contrainte mécanique.

10. Procédé selon la revendication 9 dans lequel la contrainte mécanique est appliquée sur la couche supplémentaire (609).

11. Procédé selon l'une quelconque des revendications 9 et 10 comportant une étape de suppression partielle ou totale de la couche supplémentaire (609).

12. Procédé selon la revendication 8 ou la revendication 11 dans lequel l'étape de suppression est réalisée par évaporation, par dissolution chimique ou par gravure.

13. Procédé selon l'une quelconque des revendications 1 à 12 dans lequel la matière molle est du cyclododécane ou un polymère choisi parmi les suivants : polydiméthylsiloxane, polyéthylène glycol, poly(méthacrylate de méthyle).

14. Procédé selon l'une quelconque des revendications 1 à 13 dans lequel la matière molle est un matériau présentant une propriété électrique ou optique.

## Patentansprüche

1. Ausrichtungsverfahren von länglichen Gegenständen (202), die an der Oberfläche eines Substrats (201) angeordnet sind, wobei sich die länglichen Gegenstände (202) gemäß einer anfänglichen Richtung (Z) erstrecken, wobei das Verfahren die folgenden Schritte umfasst:
- Aufbringen (S1) wenigstens einer Schicht (203) aus einem weichen Material, das einen Teil der länglichen Gegenstände wenigstens teilweise abdeckt, auf der Oberfläche des Substrats (201);
- Anwenden (S2) einer mechanischen Spannung auf wenigstens einem Teil der Schicht (203) aus weichem Material derart, dass die Ausrichtung des wenigstens einen Teils der länglichen Gegenstände (202) geändert wird.

2. Verfahren gemäß Anspruch 1, bei dem die länglichen Gegenstände (202) eine Länge gemäß ihrer anfänglichen Richtung (Z) aufweisen, wobei die Schicht (203) aus weichem Material eine Dicke aufweist, die wenigstens gleich der Länge der länglichen Gegenstände (202) ist.

3. Verfahren gemäß irgendeinem der Ansprüche 1 und 2, bei dem die auf den genannten wenigstens einen Teil der Schicht (203) aus weichem Material angewendete mechanische Spannung eine Abscherspannung und / oder eine Torsionsspannung ist.

4. Verfahren gemäß irgendeinem der Ansprüche 1 bis 3, bei dem die mechanische Spannung mittels eines Puffers angewendet wird, der einen Druck auf den genannten wenigstens einen Teil der Schicht (203) aus weichem Material ausübt.

5. Verfahren gemäß irgendeinem der Ansprüche 1 bis 4, umfassend einen Änderungsschritt (S3) der Viskosität der Schicht (203) aus weichem Material.

6. Verfahren gemäß Anspruch 5, bei dem die Änderung der Viskosität der Schicht (203) aus weichem Material mittels Glühen einer chemischen Reaktion oder eines Kontakts mit Bestrahlung ausgeführt wird.

7. Verfahren gemäß irgendeinem der Ansprüche 1 bis 6, umfassend einen Abschälschritt (S4), in dessen Verlauf die Schicht (203) aus weichem Material mit den länglichen Gegenständen (202) vom Substrat (201) getrennt ist.

8. Verfahren gemäß irgendeinem der Ansprüche 1 bis 6, umfassend einen teilweisen oder kompletten Beseitigungsschritt der Schicht (203) aus weichem Material.

9. Verfahren gemäß irgendeinem der Ansprüche 1 bis 7, umfassend einen Aufbringschritt wenigstens einer zusätzlichen Schicht (609) auf der Schicht (203) aus weichem Material vor oder nach der Anwendung der mechanischen Spannung.

10. Verfahren gemäß Anspruch 9, bei dem die mechanische Spannung auf die zusätzliche Schicht (609) angewendet wird.

11. Verfahren gemäß irgendeinem der Ansprüche 9 und 10, umfassend einen teilweisen oder vollständigen Beseitigungsschritt der zusätzlichen Schicht (609).

12. Verfahren gemäß Anspruch 8 oder Anspruch 11, bei dem der Beseitigungsschritt per Verdampfen, per chemischer Auflösung oder per Gravur realisiert wird.

13. Verfahren gemäß irgendeinem der Ansprüche 1 bis 12, bei dem das weiche Material Cyclodecan oder ein Polymer ist, das aus den folgenden ausgewählt ist: Polydimethylsiloxan, Polyethylenglykol, Poly(methylmethacrylat).

14. Verfahren gemäß irgendeinem der Ansprüche 1 bis 13, bei dem das weiche Material ein Material ist, das eine elektrische oder optische Eigenschaft aufweist.

## Claims

1. A method for orienting elongated objects (202) arranged on a surface of a substrate (201), the elongated objects (202) extending according to an initial orientation (Z), the method comprising the following steps:
- depositing (S1) on the surface of the substrate (201) at least one layer (203) of a soft material covering at least partially a portion of the elongated objects;
- applying (S2) a mechanical stress on at least one portion of the layer (203) of soft material in such a way as to modify the orientation of at least one portion of the elongated objects (202).

2. The method according to claim 1 wherein the elongated objects (202) have a length according to their initial orientation (Z), the layer (203) of soft material having a thickness at least equal to the length of the elongated objects (202).

3. The method according to any of claims 1 and 2 wherein the mechanical stress applied on said at least one portion of the layer (203) of soft material is a shear stress and/or a torsional stress.

4. The method according to any of claims 1 to 3 wherein the mechanical stress is applied by means of a bumper exerting a pressure on said at least one portion of the layer (203) of soft material.

5. The method according to any of claims 1 to 4 comprising a step of modifying (S3) the viscosity of the layer (203) of soft material.

6. The method according to claim 5 wherein the modification of the viscosity of the layer (203) of soft material is carried out by means of an annealing, a chemical reaction or exposure to radiation.

7. The method according to any of claims 1 to 6 comprising a step of peeling (S4) during which the layer (203) of soft material, with the elongated objects (202), is separated from the substrate (201).

8. The method according to any of claims 1 to 6 comprising a step of partially or entirely removing of the layer (203) of soft material.

9. The method according to any of claims 1 to 7 comprising a step of depositing of at least one additional layer (609) on the layer (203) of soft material, before or after the application of the mechanical stress.

10. The method according to claim 9 wherein the mechanical stress is applied on the additional layer (609).

11. The method according to any of claims 9 and 10 comprising a step of partially or entirely removing he additional layer (609).

12. The method according to claim 8 or claim 11 wherein the step of removal is carried out by evaporation, by chemical dissolution or by etching.

13. The method according to any of claims 1 to 12 wherein the soft material is cyclododecane or a polymer chosen from among the following: polydimethylsiloxane, polyethylene glycol, poly(methyl methacrylate).

14. The method according to any of claims 1 to 13 wherein the soft material is a material that has an electrical or optical property.
